# EUROPEAN PATENT APPLICATION

(11) **EP 0 928 128 A1**
(43) Date of publication of application: **07.07.1999**
(21) Application number: 98124790.1
(22) Date of filing: 29.12.1998
(51) Int. Cl.: H05K 3/34

(54) **Soldering of liquid crystal display modules on the edge of printed circuit boards**

(30) Priority: 29.12.1997 KR 9776052
(71) Applicant: SAMSUNG ELECTRONICS Co. Ltd., Kyungki-do, Seoul (KR)
(72) Inventor: Jung, Jae-lk, Taegukwangyok-shi (KR)
(74) Representative: Grünecker, Kinkeldey, Stockmair & Schwanhäusser Anwaltssozietät

(57) **Abstract**

There is provided a connection structure between an LCD (Liquid Crystal Display) module and a PCB (Printed Circuit Board) portable phone, preferably in a flip-up type phone. In the connection structure, a plurality of terminals are connected to LED (Light Emitting Diode) back lights of the LCD module and has connection portions exposed from both sides of the LCD module with use of a frame integrally fixed to the terminals, and a plurality of grooves are formed at positions corresponding to the terminals on the PCB. The terminals are soldered in the grooves so as to make contact between the LED back lights and the PCB.

## Description

The present invention relates to a portable phone like a PCS (Personal Communication Service) phone, a CT-2 (Cordless Phone-2), a digital phone, and a cellular phone, and in particular, to the connection between an LCD (Liquid Crystal Display) module and a PCB (Printed Circuit Board) in a portable phone.

Among portable communication terminals, portable phones and more particular flip-type phones is currently coming into wide use. This is attributed to its advantage of a flip for protecting a plurality of keys and acting as a sound reflecting plate and thus voice quality higher than that of a bar-type one.

Flip-type portable phones are divided into two kinds depending on flip position: flip-down type and flip-up type.

In a flip-down type portable phone, a flip is opened downward. Thus, a hinge mechanism for opening the flip is provided to the lower end of a body.

On the other hand, a flip-up type portable phone is opened upward and an LCD portion for displaying data is always exposed. Thus, hinge mechanisms are symmetrically provided at both sides of the LCD portion.

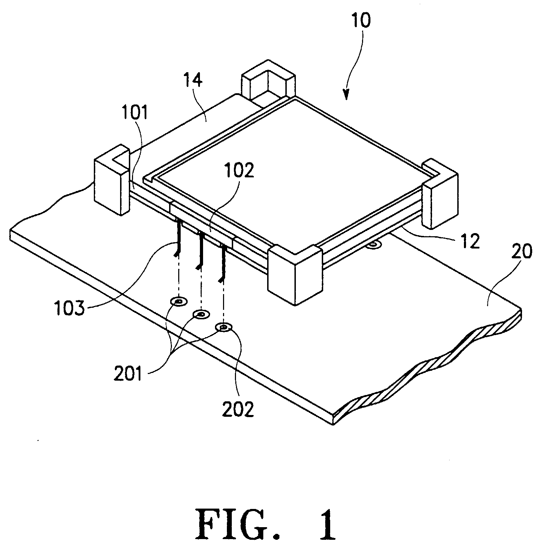

FIG. 1 illustrates a connection structure between an LCD module and a PCB of a body in a conventional flip-up type portable phone.

Referring to FIG. 1, a general LCD module 10 is electrically connected to a PCB 12 on the body by a flexible printed circuit 14. LED (Light Emitting Diode) back lights (not shown) are provided to the LCD module 10, for backlighting the LCD module 10 when a flip is opened from the body, and a plurality of leads 103 are formed at both sides of the LCD module 10, for connecting the LED back lights with a PCB 20 of the body. Ends of the leads 103 are connected to the LED back lights and fixed to a frame 102, and the other ends thereof are inserted into connection holes 201 of the PCB 20 and connected to the PCB 20 by soldering to the topsurface of the PCB 20. Lands 202 are formed around the holes 201.

The above connection structure between the LCD module and the body PCB , however, has the following problems.

To solder the leads to the body PCB through holes and lands, as many holes and lands as LEDs are required, occupying as much area and thus increasing the size of the LCM module. Further, use of the leads , soldered to the top surface of the PCB causes the LCD module to be installed higher, making it difficult to achieve a slim body. With the leads soldered to the PCB, the LCD module is spaced from the PCB and susceptible to a shock.

An object of the present invention is to provide a connection structure between an LCD module and a PCB portable phone, and more particularly in a flip-up type portable phone, which occupies a minimum area to conserve a maximum area for parts of the PCB and which can minimize an impact on LED leads of the LCD module when the portable phone falls down.

To achieve the above objects, there is provided a connection structure between an LCD module and a PCB in a portable phone having the features of claim 1. In such a connection structure, a plurality of terminals are connected to LED back lights of the LCD module and has connection portions exposed from both sides of the LCD module with use of a frame integrally fixed to the terminals, and a plurality of grooves are formed at positions corresponding to the terminals on the PCB. The terminals are soldered in the grooves so as to make contact between the LED back lights and the PCB.

Prefered embodiments of the invention are specified in the depending claims.

The above objects and advantages of the present invention will become more apparent by describing in detail a preferred embodiment thereof with reference to the attached drawings in which:
FIG. 1 is a perspective view of a connection structure between an LCD module and a PCB in a conventional flip-up type portable phone;
FIG. 2 is a perspective view of a connection structure between an LCD module and a PCB in a flip-up type portable phone according to a preferred embodiment of the present invention; and
FIG. 3 is a partial sectional perspective view of the connection structure of Fig.2 between the LCD module and the PCB in the flip-up type portable phone.

A preferred embodiment of the present invention will be described referring to the attached drawings. It is to be noted that like reference numerals denote the same components in the drawings, and a detailed description of a known structure or function of the present invention is omitted herein if it is deemed to obscure the subject matter of the present invention.

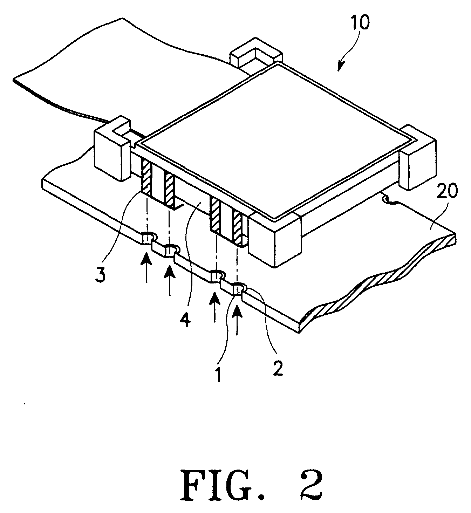

Referring to FIG. 2, an LCD module 10 in the present invention is applied to a portable device such as a PCS phone, a CT-2, and the like, especially to a flip-up type portable phone. The flip-up type portable phone has a hinge mechanism at both sides of an LCD module. This has been disclosed in Korea Application No. 97-76184 filed by the present applicant.

At both sides of the LCD module 10 are also provided hinge assemblies (not shown). The LCD module 10 is installed on a body and electrically connected to a PCB 20 by terminals 3. LED back lights (not shown) are provided to the LCD module 10 and connected to the terminals 3, for enabling a user to see data displayed on the LCD module 10 in the darkness. The terminals 3 are connected to the PCB by soldering in them in the grooves 1 in the direction indicated by arrows.

The terminals 3 include an anode terminal, a cathode terminal, and a ground terminal. They are integrally fixed to both side surfaces of the LCD module 10 by a frame 4 and fixed in the grooves 1 formed on both side surfaces of the PCB 20 at positions corresponding to the terminals 3 by soldering. Lands 2 are formed around the grooves 1 of the PCB 20.

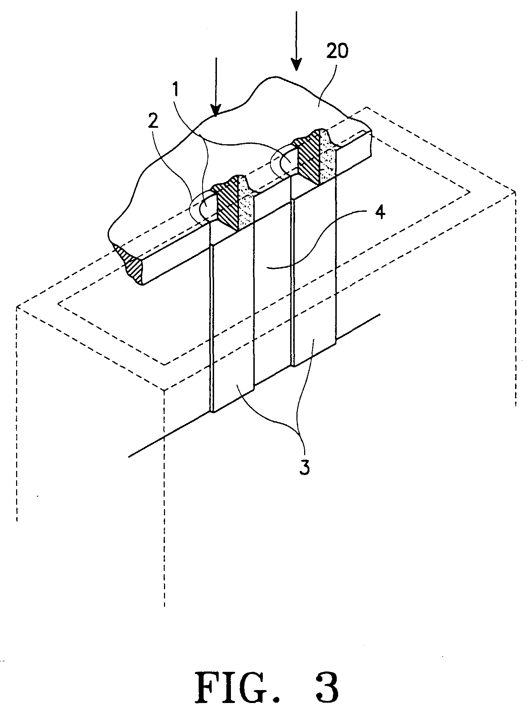

FIG. 3 shows the LCD module 10 integrally fixed on the PCB 20. The grooves 1 are filled by soldering and thus the LED back lights are electrically connected to the PCB 20. A hinge mechanism is to be disposed in the portion defined by a dotted line in FIG. 3.

That is, when the LCD module is mounted on the PCB, the hinge assemblies used to open a flip make contact with both side surfaces of the PCB, leaving only the space of the grooves. Then, the grooves are filled by soldering. Thus, the LED back lights of the LCD module are electrically connected to the PCB by the terminals and soldering.

As described above, the present invention facilitates connection between the LCD module and the PCB, and is highly resistant against a shock because there is a little gap only between the LCD module and the PCB by assembling the terminals of the LCD module to the PCB and then soldering them. Further, the connection structure between the LCD module and the PCB reduces the thickness of the portable phone body, contributing to miniaturization of the portable phone, and conserves a maximum area for parts of the PCB.

## Claims

1. A portable phone including an LCD (Liquid Crystal Display) module (10) and a PCB (20) (Printed Circuit Board), comprising:
a plurality of terminals (3) connected to LED (light Emitting Diode) back lights of the LCD module (10) and having connection portions exposed from both sides of the LCD module (10) fixed to the terminals (3) and
a plurality of grooves (1) formed at positions corresponding to the terminals (3) on the PCB (20),
wherein the terminals (3) are soldered in the grooves (1) so as to make contact between the LED back lights and the PCB (20).

2. A portable phone in accordance with claim 1,
**characterized in that**
said portable phone is a flip-up type portable phone.

3. A portable phone in accordance with claim 1 or 2,
**characterized in that**
said terminals (3) are integrally fixed to said both sides of the LCD module (10) with use of a frame (4).

4. A portable phone in accordance with any of claims 1 to 3,
**characterized in that**
said terminals (3) include an anode terminal, a cathode terminal, and a ground terminal.
